# EUROPÄISCHE PATENTSCHRIFT

(11) **EP 2 340 556 B1**
(45) Veröffentlichungstag und Bekanntmachung des Hinweises auf die Patenterteilung: **08.08.2012**
(21) Anmeldenummer: 09740259.8
(22) Anmeldetag: 18.09.2009
(51) Int. Cl.: H01L 21/677, H01L 31/18

(54) **HERSTELLVERFAHREN UND HERSTELLVORRICHTUNG FÜR STRINGS**
PRODUCTION METHOD AND PRODUCTION DEVICE FOR STRINGS
PROCÉDÉ ET DISPOSITIF DE FABRICATION DE CHAÎNES D'ÉLÉMENTS SOLAIRES

(30) Priorität: 18.09.2008 DE 202008012449 U
(43) Veröffentlichungstag der Anmeldung: 06.07.2011
(73) Patentinhaber: KUKA Systems GmbH, 86165 Augsburg (DE)
(72) Erfinder: SCHÄRTL, Elisabeth, 85221 Dachau (DE); VONTZ, Albert, 89143 Blaubeueren (DE); SCHMID, Markus, 81679 München (DE); HERZ, Frank, 86316 Friedberg (DE)
(74) Vertreter: Ernicke, Klaus Stefan
(86) Internationale Anmeldenummer: PCT/EP2009/006762
(87) Internationale Veröffentlichungsnummer: WO 2010/031571

(56) Entgegenhaltungen:
- EP-A- 1 873 844
- WO-A-03/059570
- WO-A-03/098704
- DE-A1- 3 238 187
- DE-A1-102006 007 447
- NOWLAN M J ET AL: "ADVANCED AUTOMATION TECHNIQUES FOR INTERCONNECTING THIN SILICON SOLAR CELLS" WORLD CONFERENCE ON PHOTOVOLTAIC ENERGY. WAIKOLOA, DEC. 5 - 9, 1994; [WORLD CONFERENCE ON PHOTOVOLTAIC ENERGY], NEW YORK, IEEE, US, Bd. CONF. 1, 5. Dezember 1994 (1994-12-05), Seiten 828-831, XP000681346

## Beschreibung

Die Erfindung betrifft ein Herstellverfahren und eine Herstellvorrichtung für Strings mit den Merkmalen im Oberbegriff des Verfahrens- und Vorrichtungshauptanspruchs.

Eine solche Herstellvorrichtung ist für die Fotovoltaikzellenverarbeitung aus der EP 1 873 844 A1 bekannt. Sie dient zur Herstellung von Strings, die aus mehreren Solarzellen bestehen, die untereinander durch angelötete metallische Verbindungselemente verbunden sind. Die Herstellvorrichtung weist Zuführeinrichtungen für die Solarzellen und die Verbinder sowie eine Löteinrichtung auf. Ferner ist eine Transporteinrichtung mit einem umlaufend angetriebenen Förderband vorhanden, welches aus einer Kette von Kunststoffplatten besteht, die auf einem Träger aufliegen. Die Solarzellen werden auf den Kunststoffplatten einzeln aufgelegt und durch Unterdruck festgehalten. Die fertigen Strings werden am Ende der Fertigungslinie vom Förderband abgenommen und einer Prüfeinrichtung zugeführt. Die vorbekannte Herstellvorrichtung erfordert ein mehrmaliges Greifen und Aufnehmen der Fotovoltaikzellen mittels Sauggreifern.

Es ist Aufgabe der vorliegenden Erfindung, eine bessere Herstelltechnik aufzuzeigen.

Die Erfindung löst diese Aufgabe mit den Merkmalen im Verfahrens- und Vorrichtungshauptanspruch.

Die beanspruchte Herstelltechnik hat den Vorteil, dass Solarelemente nur einmal beim Beladen des Werkstückträgers gegriffen werden müssen. Dies kann schonend und insbesondere ohne Berührungskontakt mit der empfindlichen Oberfläche, der sog. Sonnenseite, geschehen. Anschließend können die Solarelemente zusammen mit dem Werkstückträger gehandhabt und transportiert werden. Sie können am Ende des Herstellungsprozesses und ggf. nach einer Prüfung als String an eine Weiterverarbeitung abgegeben werden. Die Solarelemente können während des gesamten Fertigungsprozesses nur einmal gehandhabt und ggf. fixiert werden. Dies minimiert die Beschädigungsgefahr und die Bruchrate.

Der Werkstückträger vereinfacht und verbessert die Handhabung der Solarelemente, wobei außerdem der String auf dem Werkstückträger gebildet werden kann. Die Verbindung der Solarelemente untereinander im String kann in beliebig geeigneter Weise erfolgen, z.B. durch metallische Verbindungselemente, die in geeigneter Weise an die Solarelemente gefügt, beispielsweise gelötet werden. Der Werkstückträger ermöglicht hierbei einen lagegenauen und sicheren Flächenkontakt zwischen den Solarelementen und den Verbindungselementen, was für die Fügequalität vorteilhaft ist. Er bietet außerdem eine Führung und sichere Abstützung für die Solar- und Verbindungselemente. Die Solarelemente können in beliebig geeigneter Weise ausgebildet sein und z.B. aus mono- oder polykristallinen Wafern oder aus Solarzellen bestehen. Insbesondere können die Solarzellen an der Rückseite mit Leiterbahnen bedruckt oder beschichtet sein und hier auch elektrisch leitend zu einem sogenannten Rückkontaktstringer verbunden werden.

Die bevorzugt scheibenförmigen Solarelemente können am Werkstückträger exakt positioniert und mittels einer Halteeinrichtung festgehalten werden, wobei auch eine genaue Lagezuordnung zu ggf. vorhandenen Verbindungselementen geschaffen werden kann. Die Solarelemente können mit der Sonnenseite nach oben auf den Werkstückträger und über den vorher bereits eingelegten Verbindungselemente platziert werden. Das Fügen und insbesondere Löten kann von der Rückseite oder Unterseite her und durch Öffnungen im Boden des Werkstückträgers erfolgen und belastet nicht die empfindliche Sonnenseite der Solarelemente. Andererseits kann der fertige String mit der Sonnenseite auf eine Prüfeinrichtung abgelegt werden. Beim Prüfen kann der String vom Werkstückträger festgehalten und erst für die Weiterverarbeitung, z.B. an einer Zusammenbaueinrichtung für Solarmodule abgegeben werden.

Der Transport des mit dem String beladenen Werkstückträgers kann während der Stringherstellung durch eine Transporteinrichtung innerhalb einer Fertigungseinrichtung erfolgen. Die weitere Handhabung nebst Transport des Werkstückträgers und des Strings kann durch eine Handhabungseinrichtung, z.B. einen mehrachsigen Manipulator, geschehen. Die Handhabungseinrichtung kann leere Werkstückträger der Fertigungseinrichtung zuführen und im Gegenzug Werkstückträger mit Strings von der Fertigungseinrichtung abnehmen und weiteren Bearbeitungsschritten, z.B. einer Prüfung, einer Weiterbearbeitung oder dgl. zuführen.

Mit der beanspruchten Herstellungs- und Handhabungstechnik werden die Solarelemente und die Strings mit größtmöglicher Schonung behandelt. Hierbei kann eine maximale Fertigungsqualität erreicht werden, was eine exakte Stringbildung mit genauer Platzierung der Solarelemente und der ggf. vorhandenen Verbindungselemente nebst hoher Fügequalität einschließt. Andererseits können Beschädigungen oder andere Beeinträchtigungen der empfindlichen Solarelemente vermieden werden. Die beanspruchte Technik bietet außerdem eine maximale Flexibilität und Fertigungsgeschwindigkeit. Sie erlaubt durch Austausch oder Umbau der Werkstückträger eine schnelle und einfache Anpassung an unterschiedliche Solarelementformate oder Stringgrößen. Durch ein geeignetes Handhabungswerkzeug kann außerdem der Wechsel der leeren und beladenen Werkstückträger sehr schnell und mit hoher Genauigkeit erfolgen.

Die Solarelemente und die ggf. vorhandenen Verbindungselemente können durch die Halteeinrichtung während der Herstellung und auch während der Transport-und Übergabephasen sicher und lagegenau am Werkstückträger gehalten werden. Sie können durch den exakten Lagebezug auch über den Werkstückträger exakt gegenüber den Zuführ-und Fügeeinrichtungen sowie einer evtl. vorhandenen Prüfeinrichtung positioniert werden.

Die beanspruchte Herstellvorrichtung kommt mit einem geringen Platzbedarf und Bauaufwand aus. Sie ist besonders wirtschaftlich.

In den Unteransprüchen sind weitere vorteilhafte Ausgestaltungen der Erfindung angegeben.

Die Erfindung ist in den Zeichnungen beispielsweise und schematisch dargestellt. Im einzelnen zeigen:
- Figur 1:: eine perspektivische Ansicht einer Herstellvorrichtung für Strings aus Solarelementen,
- Figur 2:: eine vergrößerte Draufsicht auf einen Teil der Herstellvorrichtung von Figur 1,
- Figur 3:: eine vergrößerte Teilansicht von Verbindungselementen und einer zugehörigen Zuführvorrichtung,
- Figur 4:: einen Werkstückträger für einen String aus mehreren Solarelementen in perspektivischer Darstellung,
- Figur 5 bis 7:: eine Draufsicht und geklappte Stirn- und Seitenansichten des Werkstückträgers von Figur 4,
- Figur 8:: einen vergrößerten Querschnitt durch den Werkstückträger gemäß Schnittlinie VIII-VIII von Figur 5,
- Figur 9:: einen vergrößerten Ausschnitt der Draufsicht des Werkstückträgers von Figur 5,
- Figur 10:: eine perspektivische Darstellung eines Handhabungswerkzeugs für mehrere Werkstückträger,
- Figur 11 bis 13:: eine Draufsicht und geklappte Seiten- und Stirnansichten des Handhabungswerkzeugs von Figur 10,
- Figur 14:: ein Querschnitt durch das Handhabungswerkzeug gemäß Schnittlinie XIV-XIV von Figur 11,
- Figur 15:: eine schematische Ansicht einer Herstellanlage für Solarmodule mit einer Herstellvorrichtung für Strings,
- Figur 16:: eine perspektivische Ansicht einer Variante der Herstellvorrichtung,
- Figur 17:: einen vergrößerten Ausschnitt einer Zuführeinrichtung an der Herstellvorrichtung von Figur 16 und
- Figur 18:: einen anderen vergrößerten Ausschnitt einer Zuführeinrichtung an der Herstellvorrichtung von Figur 16.

Die Erfindung betrifft eine Herstellvorrichtung (2) für Strings (3) aus mehreren untereinander verbundenen Werkstücken (4), bei denen es sich in der gezeigten und bevorzugten Ausführungsform um Solarelemente handelt. Die Erfindung betrifft ferner eine Herstellanlage (1) für Solarmodule (7) oder andere größere Bauteile, wobei die Anlage (1) mindestens eine Herstellvorrichtung (2) aufweist. Außerdem befasst sich die Erfindung mit einem speziellen Werkstückträger (11), der besonders für die beanspruchte Herstellvorrichtung (2) und die Herstellanlage (1) geeignet ist. Schließlich wird von der Erfindung auch ein Verfahren zum Herstellen und Handhaben von Strings (3) aus den besagten Werkstücken bzw. Solarelementen (4) erfasst.

Die Werkstücke (4) können in beliebiger Weise ausgebildet sein. Sie haben bevorzugt eine flache Plattenform. Im gezeigten und bevorzugten Ausführungsbeispiel handelt es sich um Solarelemente (4). Dies können z.B. die rohen Wafer oder andere Solarsubstrate sein. Alternativ kann es sich um Weiterverarbeitungsprodukte der Wafer und z.B. um Solarzellen handeln, die auf der Rückseite eine Schicht mit Leitungsverbindungen oder dgl. aufweisen. Die z.B. scheibenförmigen Werkstücke oder Solarelemente (4) besitzen eine solaraktive, empfindliche Oberseite (5) oder Oberfläche, die auch als Sonnenseite bezeichnet wird und die bei einem Solarmodul (7) dem einfallenden Licht zugewandt ist. Die Rückseite oder Unterseite ist weniger empfindlich. Nachfolgend wird die Erfindung anhand von Solarelementen (4) beschrieben. Die Offenbarung gilt auch für andere Arten von Werkstücken, ggf. mit einer entsprechenden Adaption an die Werkstückerfordernisse.

Die Solarelemente (4) werden untereinander zu einer Kette oder einem String (3) verbunden. Der String (3) kann eine Reihenform haben, wie sie in den Ausführungsbeispielen dargestellt ist. Alternativ kann der String (3) mehrere Reihen umfassen und auch ein größeres Flächenelement mit regelmäßigen oder unregelmäßigen Formen bzw. Umrissen darstellen und eine Rasteranordnung von Solarelementen (4) aufweisen.

Die Solarelemente (4) bilden Stringteile und werden untereinander in beliebig geeigneter Weise verbunden. Dies kann auf direkten Weg und ggf. mit gegenseitigem Elementkontakt erfolgen. In der gezeigten Ausführungsform werden weitere Stringteile (6) zwischen die Solarelemente (4) eingelegt. Hierbei kann es sich um Verbindungselemente handeln, die mit den Solarelementen (4) gefügt werden. Das Fügen kann z.B. durch Löten oder auf andere beliebige Weise geschehen. Innerhalb des Strings (3) sind die Solarelemente (4) an den Verbindungsstellen mit einem gegenseitigen Abstand angeordnet, der vom Verbindungselement (6) überbrückt wird.

Die Verbindungselemente (6) können im gezeigten Ausführungsbeispiel an der Rückseite benachbarter Solarelemente (4) angeordnet und mit den dortigen Leiterbahnen elektrisch leitend verbunden werden. Die Verbindungselemente (6) können in einer anderen Ausführungsform eine elektrische Verbindung zwischen Ober-und Unterseite benachbarter Solarelemente bilden und dementsprechend ausgebildet und angeordnet sein.

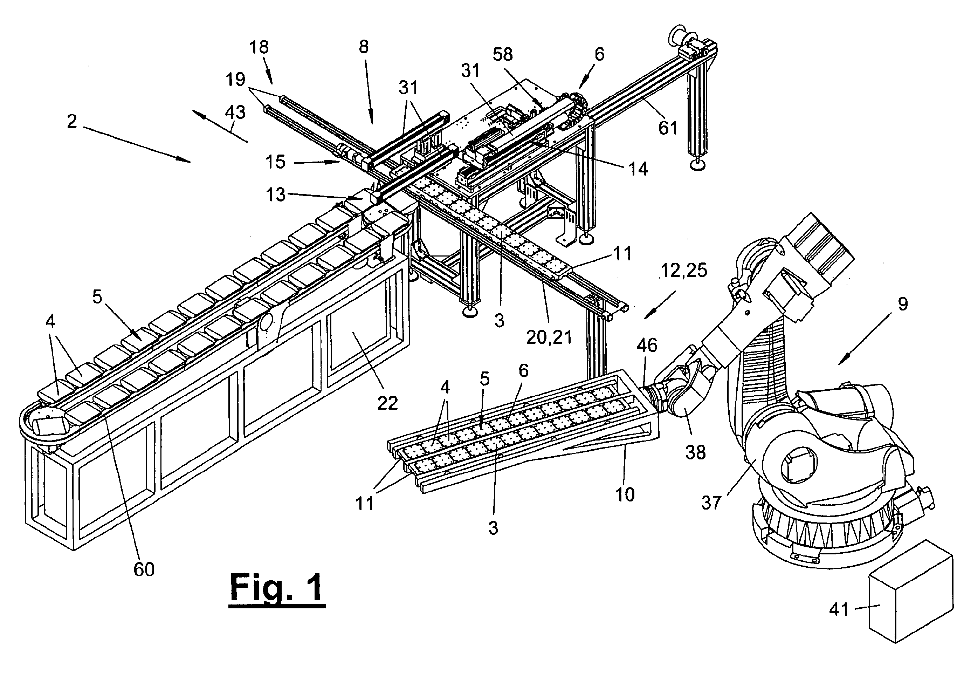

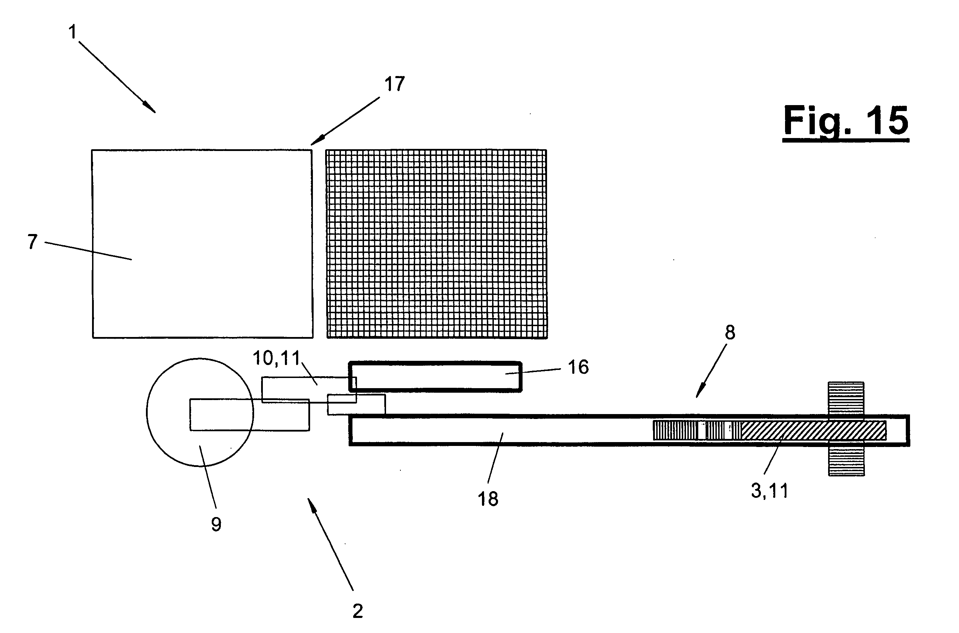

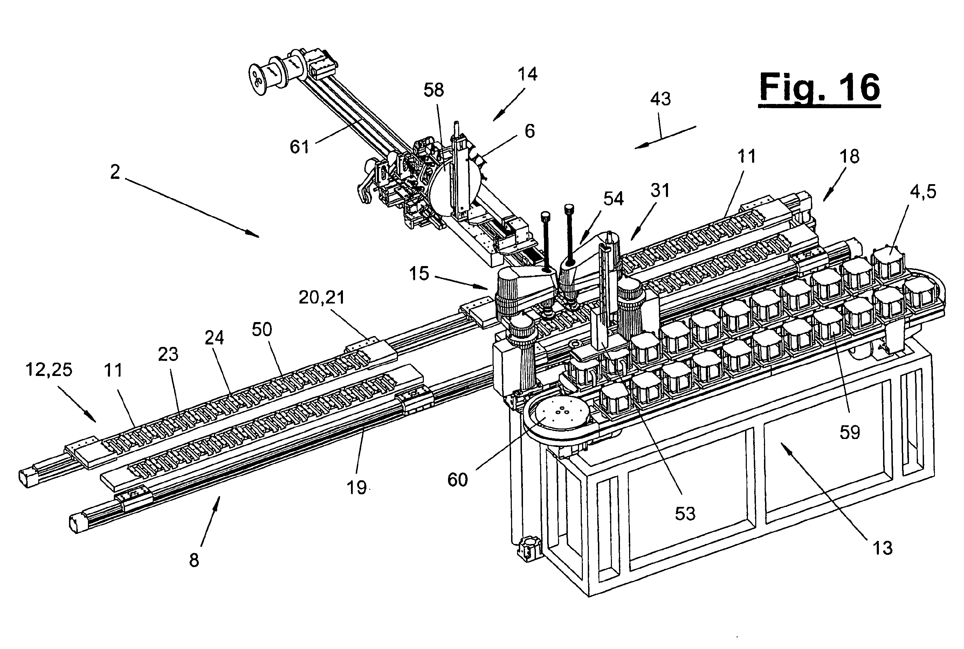

Figur 1 zeigt eine erste Ausführungsform einer Herstellvorrichtung (2) für die besagten Strings. In Figur 16 ist eine Variante dargestellt. In Figur 15 ist eine Herstellanlage (1) für Solarmodule (7) zu sehen, die eine oder mehrere Herstellvorrichtungen (2) und eine Zusammenbaueinrichtung (17) für das Solarmodul (7) aufweist.

Derartige Herstellvorrichtungen (2) werden auch als Stringer bezeichnet. Die Herstellvorrichtung (2) weist eine Transporteinrichtung (18), mindestens eine Zuführeinrichtung (13,14) für die Stringteile (4,6) und eine Fügeeinrichtung (15) für die Stringteile (4,6) auf. Diese Einrichtungen (13,14,15,18) bilden z.B. eine Fertigungseinrichtung (8) oder Fertigungslinie. Ferner kann die Herstellvorrichtung (2) eine Handhabungseinrichtung (9) umfassen, die z.B. aus einem mehrachsigen Manipulator (37) mit einem Werkzeug (10) besteht und nachstehend näher erläutert wird. Die Herstellvorrichtung (2) kann auch eine Prüfeinrichtung (16) beinhalten, die alternativ der Anlage (1) zugeordnet sein kann.

Die Herstellvorrichtung (2) arbeitet mit einem oder mehreren Werkstückträgern (11), die zur Bildung und Aufnahme von mindestens einem String (3) dienen und die von der Handhabungseinrichtung (9) gehandhabt werden und insbesondere der Transporteinrichtung (18) zugeführt und von dieser entnommen werden. Mit der Handhabungseinrichtung (9) können der oder die Werkstückträger (11) auch der Prüfeinrichtung (16) und der Zusammenbaueinrichtung (17) für die besagten Solarmodule (7) zugeführt werden. Der Werkstückträger (11) hat eine eigenständige erfinderische Bedeutung und wird ebenfalls nachfolgend näher beschrieben.

In der Herstellvorrichtung (2), insbesondere der Fertigungseinrichtung (8), kann der Werkstückträger (11) mit Solarelementen (4) und Verbindungselementen (6) bestückt werden, die anschließend gefügt werden, wobei der fertige String (3) entsteht. Das Bestücken und Fügen kann schrittweise und unmittelbar aufeinander folgend geschehen. Der Werkstückträger (11) hat eine an die gewünschte Form und Größe des Strings (3) und der Stringteile (4,6) angepasste Formgebung. Der String (3) kann während des Herstellprozesses und auch während der weiteren Handhabung des Werkstückträgers (11) und den weiteren Prozessschritten am Werkstückträger (11) verbleiben. In der gezeigten Ausführungsform wird der String (3) erst nach der Prüfung und in der Zusammenbaueinrichtung (17) abgegeben und vom Werkstückträger (11) gelöst.

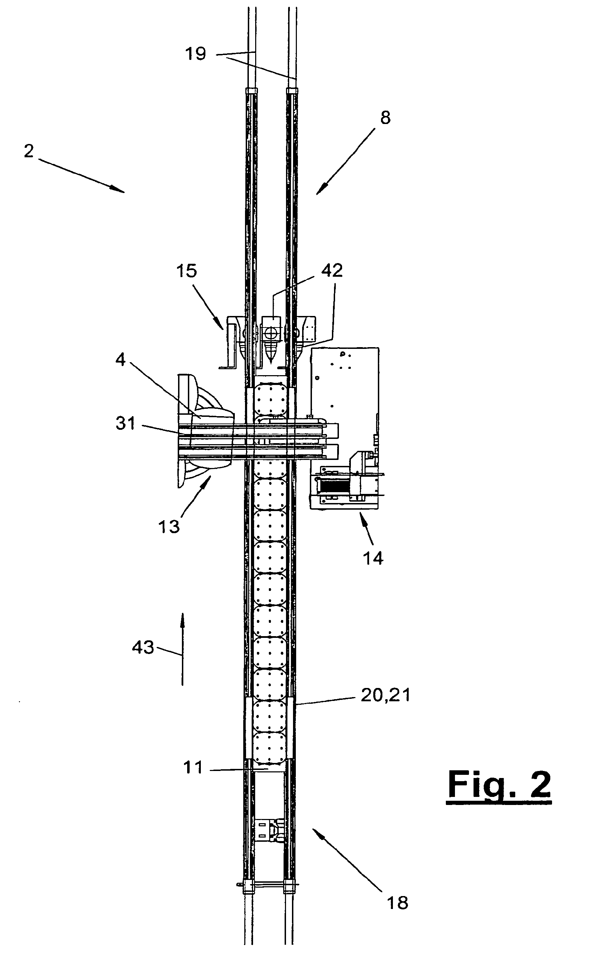

Die in Figur 1 und 2 dargestellte Transporteinrichtung (18) weist mindestens einen Förderer (20) mit mindestens einem lösbar darauf angeordneten Werkstückträger (11) zur Aufnahme von mindestens einem String (3) auf. Der Förderer (20) besitzt ein Gestell mit einer geeigneten Führung (19) für ein Fördermittel (21), z.B. einen beweglichen Schlitten, der zur positionsgenauen Aufnahme von mindestens einem Werkstückträger (11) ausgebildet ist. Es können auch mehrere Schlitten zur z.B. beidendigen Aufnahme eines Werkstückträgers (11) vorgesehen sein. Die Führung (19) kann z.B. als gerade Schienenführung ausgebildet sein. Der Förderer (20) weist einen geeigneten und vorzugsweise steuerbaren Antrieb (nicht dargestellt) für den Schlitten (21) auf. Der Förderer (20) ist schrittweise und z.B. reversierend angetrieben. Er bewegt das Fördermittel (21) mit dem Werkstückträger (11) entlang der Führung (19) für die Stringherstellung schrittweise vorwärts und anschließend in einem Zug zurück. Die Be- und Entladung des Werkstückträgers (11) erfolgt am gleichen Ende des Förderers (20). Alternativ ist ein Durchlaufbetrieb möglich. An Stelle eines Schlittens kann als Fördermittel (21) außerdem ein anderes Element, z.B. ein Schleppband oder dgl. eingesetzt werden.

Am einen Ende des Förderers (20) ist die Handhabungseinrichtung (9) angeordnet, welche den mit dem String (3) beladenen Werkstückträger (11) aufnimmt und einen neuen, leeren Werkstückträger (11) zuführt. In der gezeigten Ausführungsform ist der Förderer (20) einbahnig ausgebildet. Er kann alternativ mehrere Bahnen bzw. Führungen (19) für die parallele Fertigung mehrerer Strings (3) aufweisen. In der gezeigten Ausführungsform haben die Strings (3) eine Einzelreihen- oder Linienform. Wenn es sich um breitere und flächenförmige Gebilde handelt, ist auch die Transporteinrichtung (18) entsprechend angepasst.

Die Herstellvorrichtung (2) weist mindestens eine Positioniereinrichtung (25) für den String (3) und seine Stringteile (4,6) sowie den Werkstückträger (11) und den Schlitten (21) auf. Die Positioniereinrichtung (25) kann in beliebig geeigneter Weise ausgebildet sein und Positionsgeber mit Sensoren, Anschlägen oder dgl. sowie Stelleinrichtungen aufweisen. Die ggf. mehrteilige Positioniereinrichtung (25) ist der Übersicht halber in den Zeichnungen nur durch einen Pfeil symbolisiert und nicht im Detail dargestellt.

Die Zuführeinrichtung (14) für Verbindungselemente (6), die Zuführeinrichtung (13) für Solarelemente (4) und die Fügeeinrichtung (15) sind in Prozessablaufrichtung (43) entlang der Führung (19) hintereinander angeordnet. Sie haben dabei einen auf die Größe der Solarelemente (4) und die Fertigungsschritte abgestimmten Abstand zueinander. Hierdurch wandern der Werkstückträger (11) und Stringteile (4,6) z.B. schrittweise durch die Einrichtungen (13,14,15) und werden dort lagegenau positioniert.

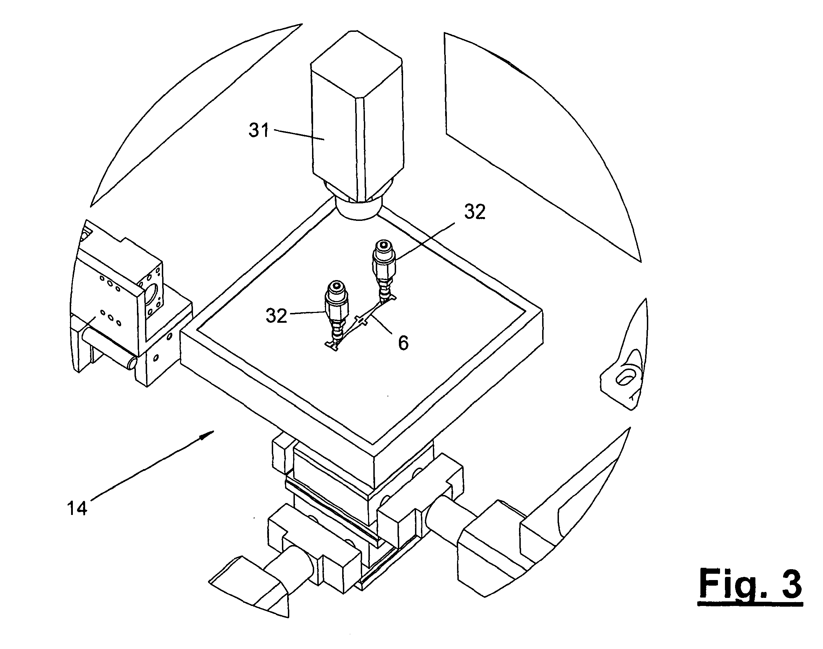

Die Zuführeinrichtungen (13,14) für die Verbindungselemente (6) und die Solarelemente (4) können in beliebig geeigneter Weise ausgebildet sein. Sie weisen z.B. ein Magazin (58) für die jeweiligen Stringteile (4,6) und einen Einleger (31) mit einem Zuführmittel (32), z.B. einem Sauger oder Picker, zur lagegenauen Aufnahme und Übergabe der Stringteile (4,6) auf. Eine solche Anordnung ist z.B. in Figur 3 dargestellt. Das Solarelement (4) kann am Rand und/oder an seiner Oberfläche gegriffen werden.

Für die Zuführeinrichtung (13) der Solarelemente (4) kann statt eines Pickers ein Sauggreifer oder ein anderes geeignetes schonendes Zuführmittel (32) vorhanden sein. Die Magazine für die Stringteile (4,6) können starr oder beweglich, z.B. auf einem Förderer (60,61), angeordnet sein. Figur 1 zeigt z.B. einen umlaufenden Bandförderer (60) für die Zuführung von Solarelementen (4) zum Einleger (31). Die Solarelemente (4) liegen ggf. einzeln auf Tragplatten des Förderers (60). Die Zuführeinrichtungen (13,14) weisen ebenfalls eine Positioniereinrichtung zum lagegenauen Greifen und Zuführen der Stringteile (4,6) und deren lagegenaue Platzierung auf dem Werkstückträger (11) auf.

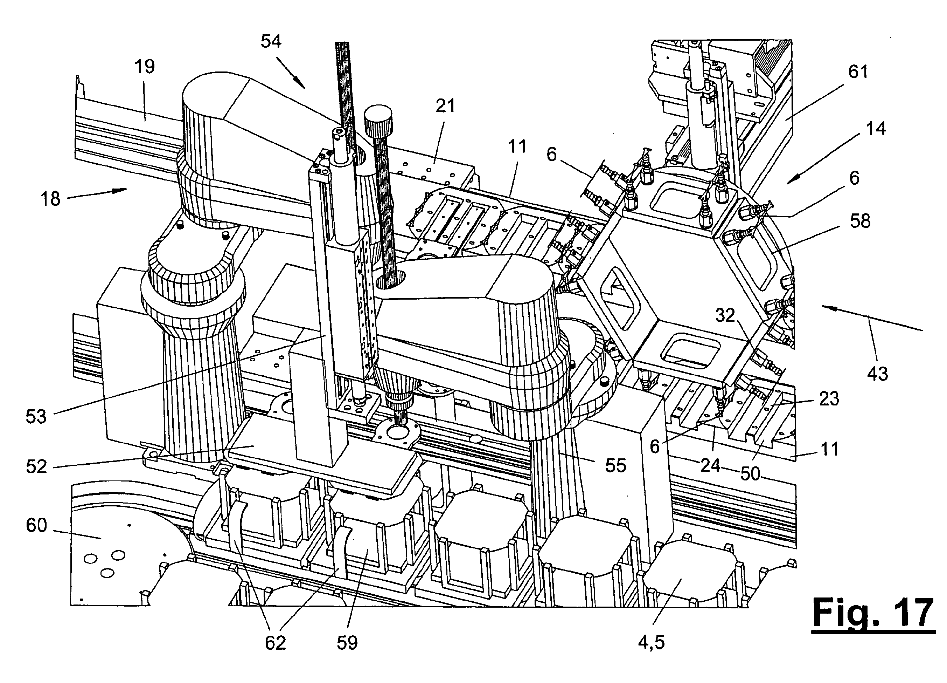

Für die Handhabung der empfindlichen Solarelemente (4) können auch berührungslose Greifer (52) eingesetzt werden, die z.B. auf der Basis eines Ultraschallluftlagers arbeiten. Ein solcher, in Figur 17 beispielhaft dargestellter Greifer (52) kann das Solarelement (4) an der Oberfläche, insbesondere an der empfindlichen Sonnenseite ohne mechanische Berührung greifen. Hierbei kann der Substratgreifer (52) mit einer Kombination von Ultraschall und Vakuum arbeiten. Mittels einer sog. Sonotrode wird ein Vakuum und eine an der Oberfläche wirkende Hebekraft auf das Solarelement (4) erzeugt. Dieser Hebekraft wirkt eine abstoßende Gegenkraft entgegen, die von einem an die Sonotrode angeschlossenen Schallwandler erzeugt wird. Hierdurch wird das Solarelement (4) schwebend und mit Abstand und somit berührungsfrei unter der Sonotrode gehalten.

Die Sonotrode kann am Einleger (31) angebaut sein und von diesem zwischen der Aufnahmestelle am Magazin und der Abgabeposition am Werkstückträger (11) hin und her bewegt werden. Für die Mitnahme und seitliche Führung des schwebenden Solarelements (4) kann ein ebenfalls am Einleger (31) oder der Sonotrode angebauter Führungsrahmen oder eine andere Führungseinrichtung vorhanden sein, wobei letztere in ähnlicher Weise wie der berührungslose Greifer mit Ultraschall arbeiten und hierdurch eine Führungsfunktion bewirken kann.

Eine ähnliche berührungslose Handhabung mittels Ultraschall ggf. Saugkraft oder Vakuum kann auch an der nachfolgend erläuterten Prüfeinrichtung (16) vorhanden sein. Ferner kann das in Figur 1 gezeigte umlaufende Magazin für die Solarelemente (4) als berührungslose Transferstrecke mit stationären Sonotroden ausgebildet sein. Über eine Schrägstellung der Bahn kann eine sichere Führung und Positionierung der Solarelemente (4) an einer seitlichen und längs der Bahn verlaufenden Führungskante erfolgen. Alternativ zur vorstehend geschilderten Variante können die Zuführeinrichtungen (13,14) auch andere Greifelemente für die Stringteile (4,6) und insbesondere auch andere bevorzugt berührungsfrei wirkende Greifer aufweisen.

Die Fügeeinrichtung (15) ist in der bevorzugten Ausführungsform als Löteinrichtung ausgebildet und weist mindestens einen Strahlkopf (42), vorzugsweise einen Laserkopf, auf, der mindestens einen energiereichen Strahl, vorzugsweise einen Laserstrahl zum Erwärmen der Lötstellen emittiert. Der energiereiche Strahl kann alternativ ein Plasmastrahl oder dgl. sein. Der Strahl-oder Laserkopf (42) besitzt eine Fokussiereinrichtung für den Strahl bzw. Laserstrahl und ist mit einer geeigneten Strahlquelle bzw. Laserquelle (nicht dargestellt) verbunden. Die Strahlemission kann intermittierend erfolgen. Die Verbinder (6) sind zum Fügen, insbesondere Löten entsprechend vorbereitet und mit einem Flussmittel sowie einem Lot versehen und insbesondere an der Oberseite beschichtet. In der gezeigten Ausführungsform sind drei Laserköpfe (42) an der Unterseite der Führung (19) und unterhalb des Werkstückträgers (11) angeordnet. Sie richten ihre Laserstrahlen durch Fügeöffnungen (27) an der Unterseite des Werkstückträgers (11) auf die darüberliegenden Stringteile (4,6). Die kanalartigen Fügeöffnungen (27) erstrecken sich durch den Trägerkorpus und münden an der Trägeroberseite im Bereich der Aufnahmen (23,24) .

Die Herstellvorrichtung (2) weist ferner eine steuerbare Halteeinrichtung (12) auf, welche den String (3) und seine Stringteile (4,6) am Werkstückträger (11) hält. Die Halteeinrichtung (12) kann auch während der Transport- und Handhabungsvorgänge wirksam sein. Sie hält den String (3) z.B. auch während der abschließenden Stringprüfung am Werkstückträger (11). Die Halteeinrichtung (12) kann zu diesem Zweck in beliebiger Weise ausgebildet sein. Im gezeigten Ausführungsbeispiel ist sie als Vakuumeinrichtung ausgebildet. Alternativ kann sie mit elektrostatischen Kräften, Magnetkräften oder auf andere Weise arbeiten.

Die Halteeinrichtung (12) weist eine Halteeinheit (28), z.B. eine Vakuumeinheit, am Werkstückträger (11) auf und besitzt mindestens eine mitführbare oder ankuppelbare Versorgung (22,41) für die Halteeinheit (28), welche an der Handhabungseinrichtung (9) und der Transporteinrichtung (18) angeordnet ist. Über die Versorgung (22,41) kann die nötige Energie und Medienversorgung für die Halteeinheit (28) gewährleistet werden. Die Halteeinheit (28) kann außerdem eine Überbrückungseinrichtung (44) zur Aufrechterhaltung der Haltefunktion während der Übergaben des Werkstückträgers bei abgekuppelter Versorgung (22,41) aufweisen. Die Überbrückungseinrichtung (44) ist insbesondere bei der Übergabe des mit einem String (3) beladenen Werkstückträgers (11) von der Transporteinrichtung (18) an die Handhabungseinrichtung (9) in Funktion.

In der gezeigten Ausführungsform kann die Versorgung (22,41) eine Vakuumquelle sein, die sich z.B. stationär an der Transporteinrichtung (18) befindet und die mit der Halteeinheit (28) am Werkstückträger (11) durch flexible Schläuche, abdeckbare Kanäle oder dgl. verbunden ist und deren Bewegungen folgt. An der Handhabungseinrichtung (9) kann ebenfalls eine Versorgung (41), insbesondere eine Vakuumquelle, angeordnet sein.

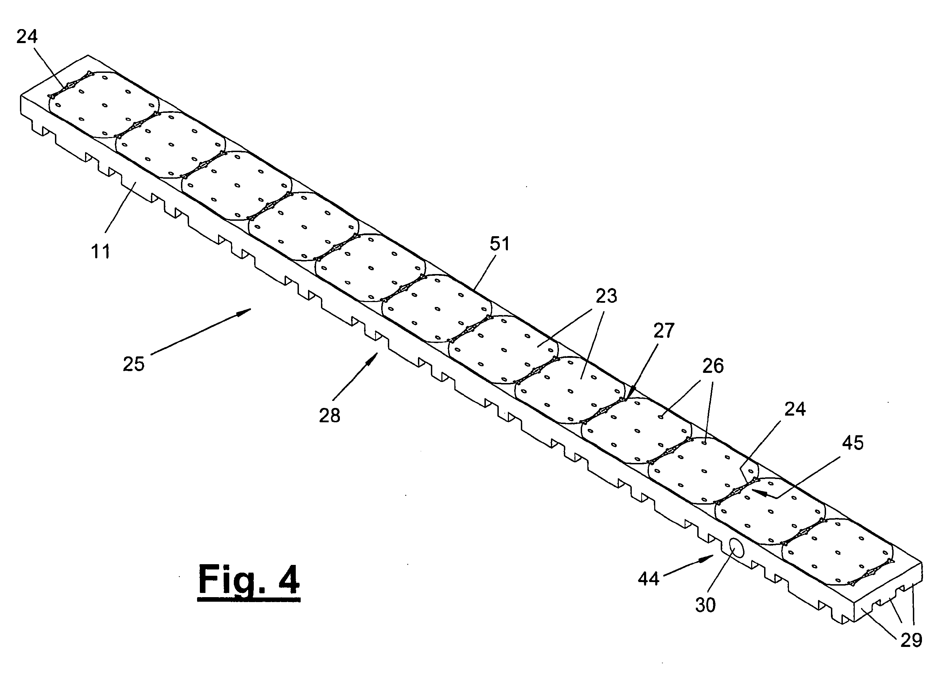

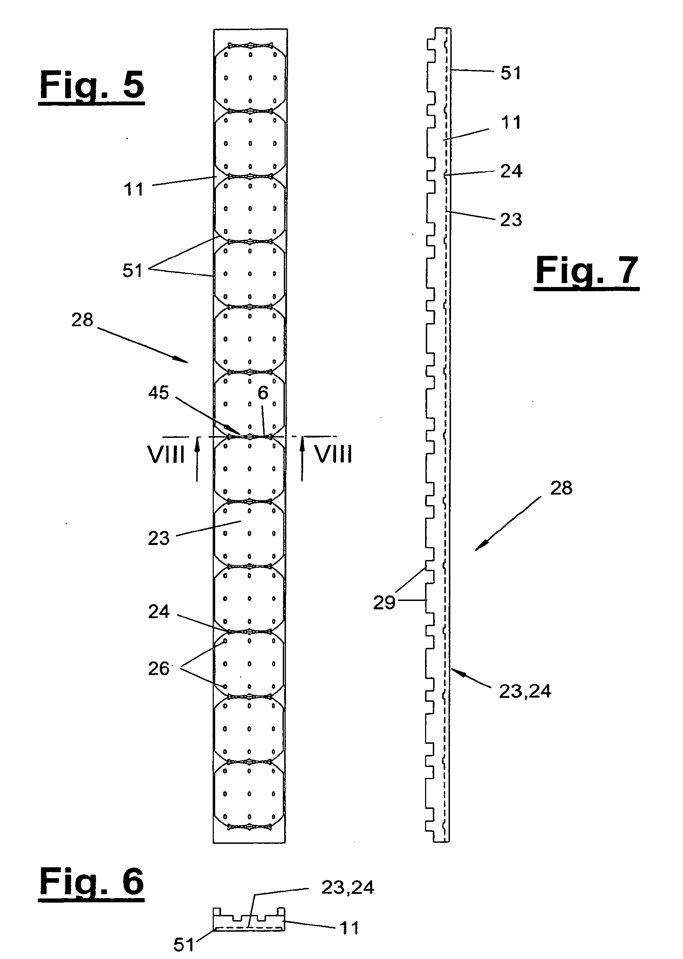

In Figur 4 bis 9 ist der Werkstückträger (11) im Detail dargestellt. Er besteht z.B. aus einer starren profilierten Leiste aus Metall, Kunststoff oder einem anderen geeigneten Material, die an der Oberseite entsprechend der Stringgeometrie mehrere Aufnahmen (23) für Solarelemente (4) und Aufnahmen (24) für Verbindungselemente (6) aufweist. Die Aufnahmen (23,24) sind an die Form der Stringteile (4,6) angepasst und abwechselnd in Stringrichtung angeordnet. Sie sind z.B. als mulden- oder wannenförmige Vertiefungen ausgebildet, deren Tiefe gleich oder kleiner als die Dicke des jeweiligen Stringteile (4,6) sein kann. Die Aufnahmen (24) für die Verbindungselemente (6) sind in einem Zwischenraum und mit einem Höhenversatz, insbesondere abgesenkt, zu den angrenzenden und gegenseitig beabstandeten Aufnahmen (23) für die Solarelemente (4) angeordnet. Die Aufnahmen (23,24) können zur exakten Positionierung der Stringteile (4,6) Führungselemente (51), z.B. seitliche Anschlagkanten, Trägerränder oder dergleichen aufweisen.

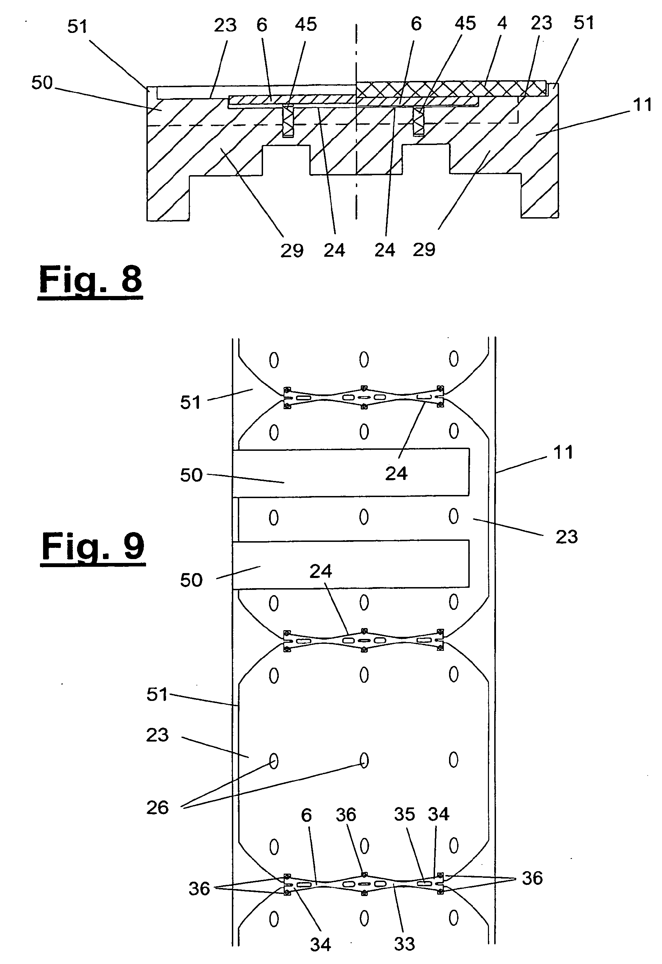

Figur 9 zeigt in der Vergrößerung die Aufnahmen (24) mit den bereits eingelegten Verbindungselementen (6). Ein Verbindungselement (6) ist auch in Figur 3 dargestellt. Es besteht z.B. aus Metall und hat eine längliche Form mit Verdickungen (34) im Bereich der Verbindungsstellen bzw. Fügepunkte (36). Es besteht z.B. aus einem Mittelsteg (33), der an beiden Enden und in der Mitte Querstege oder Arme (34) aufweist, an deren Enden jeweils ein Fügepunkt (36) vorgesehen ist. Die Fügepunkte (36) bilden die Lötpunkte. Unterhalb der Fügepunkte (36) befinden sich die entsprechenden Fügeöffnungen (27) im Werkstückträger (11). An den Enden der Verdickungen (34) und den Fügepunkten (36) liegt das Verbindungselement (6) an den Rändern der darüber liegenden, benachbarten Solarelemente (4) an und wird über die sechs Lötpunkte (36) starr fixiert. Am Mittelsteg (33) können mehrere Öffnungen (35) vorhanden sein.

Im Prozessablauf werden zunächst die Verbindungselemente (6) schrittweise von der Zuführeinrichtung (14) in die vertieften Aufnahmen (24) gelegt und hier in geeigneter Weise, z.B. durch die Halteeinrichtung (12) mit Vakuum oder dergleichen festgehalten. Auf die Verbindungselemente (6) wird anschließend von der Zuführeinrichtung (13) ein Solarelement (4) mit randseitiger Überlappung aufgelegt.

Für eine sichere Fügeverbindung, insbesondere Lötverbindung, ist ein vollflächiger Kontakt zwischen den Stringteilen (4,6) von Vorteil. Um dies zu verbessern, kann eine Einrichtung (45) zur Kontaktsicherung vorhanden sein. Diese ist in Figur 8 dargestellt und kann z.B. aus Federelementen in den Verbinderaufnahmen (24) bestehen, welche das Verbindungselement (6) von unten gegen die benachbarten Ränder der aufgelegte Solarelemente (4) drücken. Alternativ kann die Einrichtung (45) aus einer ggf. steuerbaren Blaseinrichtung bestehen, welche von unten mit einem Luftstrom für das besagte Andrücken sorgt. Hierfür kann z.B. die Halteeinrichtung (12) bzw. die Vakuumeinheit im Verbinderbereich umgesteuert und von Saugen auf Blasen umgeschaltet werden. Figur 8 zeigt in der linken Bildhälfte die Stellung des Verbindungselements (6) nach dem Einlegen, in der es unter dem Einfluss einer z.B. federnden Einrichtung (45) ein Stück über den Boden der leeren Aufnahme (23) nach oben ragt. In der rechten Bildhälfte ist die Folgesituation bei aufgelegtem Solarelement (4) und einem hiervon nach unten gedrückten Verbindungselement (6) dargestellt, welches von der Einrichtung (45) am Boden des Solarelements (4) angepresst wird. Das Solarelement (4) ragt etwas über den führenden Rand (51) hinaus nach oben.

Der Werkstückträger (11) weist im Bereich der Aufnahmen (23,24) und an deren Boden jeweils mehrere Öffnungen (26) auf, die z.B. als Saugöffnungen für die Halteeinheit (28), bzw. Vakuumeinheit ausgestaltet sind. Die Saugöffnungen (26) stehen mit Saugkanälen (29) an der Unterseite des Werkstückträgers (11) in Verbindung. Die Saugkanäle bilden ein Leitungsnetz, wobei die Fügeöffnungen (27) ausgespart sind. Die Saugkanäle (29) sind ihrerseits mit der Versorgung (22,41) durch lösbare Anschlüsse (30), insbesondere Fluidkupplungen, verbunden. An den Kupplungsstellen kann zur Bildung der vorerwähnten Überbrückungseinrichtung (44) jeweils ein selbstschließendes Ventil oder dergleichen vorhanden sein, welches beim Abkuppeln des Werkstückträgers (11) von der Versorgung (22,41) die Saugkanäle (29) verschließt und das Vakuum während des Übergabevorgangs aufrecht erhält. Beim erneuten Ankuppeln einer Versorgung (22,41) wird das besagte Ventil wieder selbsttätig geöffnet.

Die Handhabungseinrichtung (9) kann in beliebig geeigneter Weise ausgebildet sein. Im gezeigten Ausführungsbeispiel weist sie einen mehrachsigen Manipulator (37) mit einem Werkzeug (10) zur lösbaren Aufnahme von mindestens einem Werkstückträger (11) auf. Der mehrachsige Manipulator (37) kann eine beliebige Zahl und Anordnung von rotatorischen und/oder translatorischen Achsen haben. Im gezeigten Ausführungsbeispiel handelt es sich um einen Gelenkarmroboter mit sechs rotatorischen Achsen und ggf. ein oder mehreren Zusatzachsen. Der Roboter (37) besitzt eine mehrachsige Hand (38), die z.B. zwei oder drei rotatorische Achsen aufweist und an der das Werkzeug (10) angeflanscht ist. Zwischen dem Werkzeug (10) und dem Abtriebsflansch der Hand (38) kann auch eine Wechselkupplung (nicht dargestellt) angeordnet sein, die einen selbsttätigen Tausch von Werkzeugen (10) durch den Manipulator (37) ermöglicht. Hierfür kann im Arbeitsbereich des Manipulators (37) ein entsprechendes Werkzeugmagazin (nicht dargestellt) vorhanden sein.

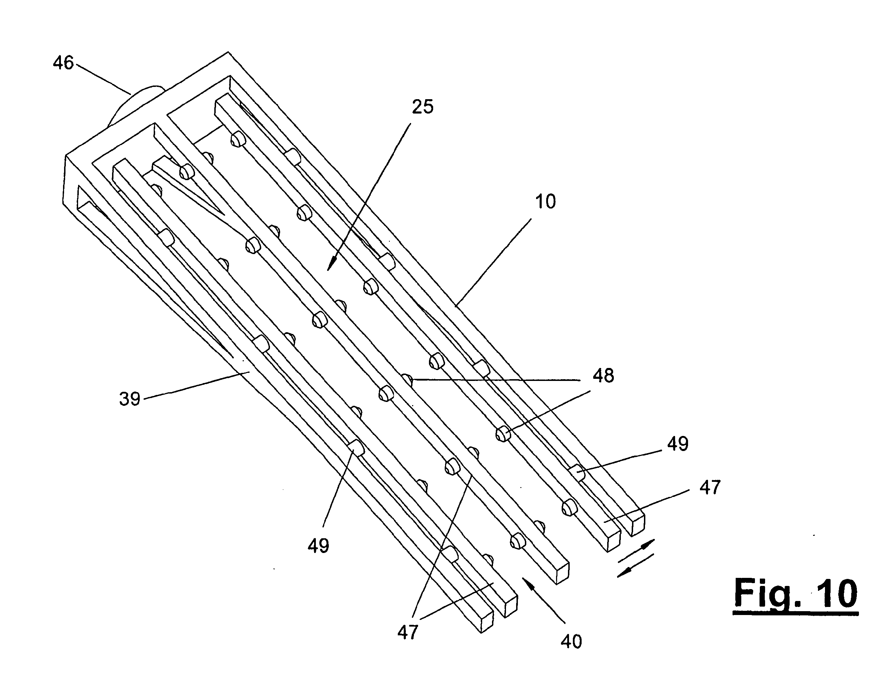

Das Werkzeug (10) kann als Wechselträger für einen oder mehrere Werkstückträger (11) ausgebildet sein und ist in Figur 10 bis 14 im einzelnen dargestellt. Es besitzt ein abgewinkeltes Gestell (39) mit einem rückseitigen Anschluss (46) zur Verbindung mit der Hand (38) oder einer Wechselkupplung. Das rahmenartige Gestell (39) bildet eine Rutsche und ermöglicht ein Aufgleiten und Abgleiten von Werkstückträgern (11) von und auf der Führung (19) der Transporteinrichtung (18). Das Gestell (39) weist hierfür eine oder mehrere z.B. lineare Führungen (40) für mindestens einen Werkstückträger (11) auf. Dies können Greifer, Klemmführungen, Gleitführungen oder Rollführungen sein, die außerdem seitliche Begrenzungen, z.B. Anschlagleisten oder dgl., zur Längsführung des Werkstückträgers (11) aufweisen.

Zum Aufladen eines Werkstückträgers (11) hält z.B. der Manipulator (37) das Werkzeug (10) mit der Führung (40) derart an den Schlitten (21), dass der Werkstückträger (11) dort an geeigneten definierten Auflagen aufgenommen oder abgegeben werden kann, wobei auch die Halteeinheit (28) an- und abgekuppelt wird. Dies kann z.B. ein definiertes und positionsgenaues Greifen und Loslassen des Werkstückträgers (11) beinhalten.

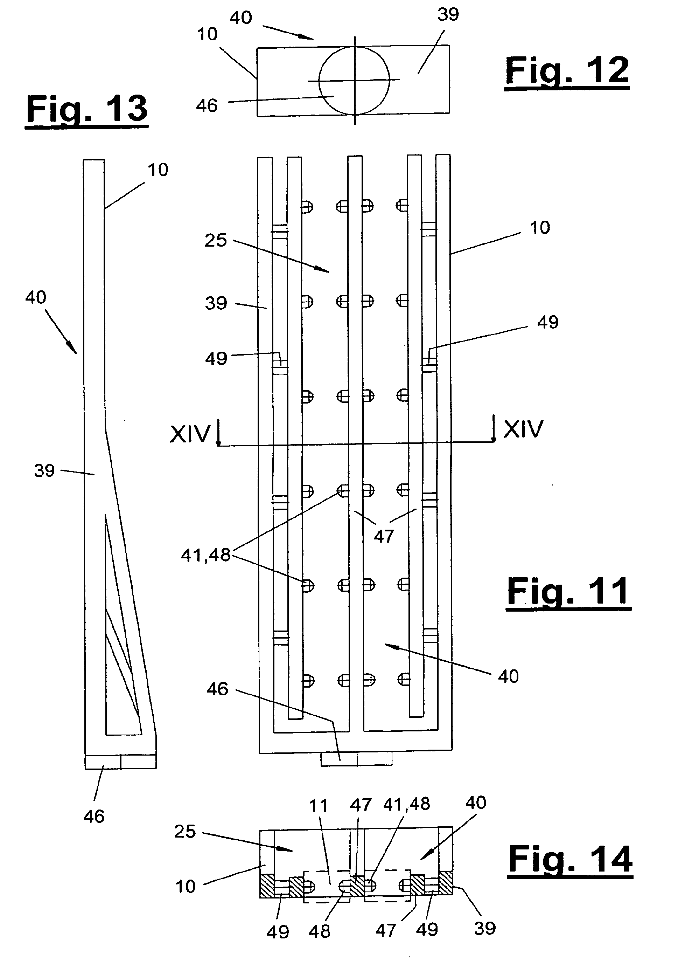

Die Führung (40) kann z.B. gemäß Figur 10 bis 14 als Klemmeinrichtung mit steuerbaren und mittels einer Stelleinrichtung (49) in Pfeilrichtung quer beweglichen parallelen seitlichen Klemmleisten (47) und einer gestellfesten zentralen Klemmleiste (47) ausgebildet sein, die den Werkstückträger (11) an seinen Seitenwänden oder am Boden unterhalb der Seitenränder mit Formschluss oder Klemmschluss greifen. An den Klemmleisten (47) und/oder am Gestell (39) können seitlich abstehende ggf. konische Zapfen (48) angeordnet sein, die Stütz- oder Greifelemente bilden können. Sie können z.B. in seitliche Öffnungen (nicht dargestellt) mindestens einer Seitenwand des Werkstückträgers (11) formschlüssig eingreifen und dabei als Positioniereinrichtung (25) auch einen Lagebezug herstellen. In Figur 14 sind die Werkstückträger (11) schematisch und gestrichelt dargestellt.

Mit den Zapfen (48) kann alternativ der untere Rand des seitlich über den Schlitten (21) überstehenden Werkstückträgers (11) bei einer Unterfahr- und Hebebewegung der Führung (40) stützend untergriffen werden, wobei die Klemmleisten (47) danach seitlich an die Seitenwände des Werkstückträgers (11) angepresst werden. Der Positionsbezug kann dabei durch Anschläge oder dgl. hergestellt werden.

Die Zapfen (48) können auch Roll- oder Gleitkörper sein, die ein Auf- und Abgleiten des Werkstückträgers (11) zwischen der Führung (40) und dem Schlitten (21) ermöglichen.

In der gezeigten Ausführungsform ist das Werkzeug (10) zur Aufnahme von zwei Werkstückträgern (11) ausgebildet. Alternativ können mehr als zwei Werkstückträger (11) oder nur ein Werkstückträger (11) aufgenommen werden. An der Führung (40) kann über die Positioniereinrichtung (25) der aufgeladene Werkstückträger (11) in eine definierte Position gebracht und dort festgehalten werden. Über diesen Lagebezug zwischen Werkstückträger (11) und Roboter (37) wird auch ein definierter Lagebezug zwischen dem String (3) und dem Roboter (37) hergestellt. Der Roboter (37) ist dadurch in der Lage, den String (3) mit dem Werkstückträger (11) positionsgenau zu handhaben und z.B. einer im Arbeitsbereich des Manipulators (37) angeordneten Prüfeinrichtung (16) zuzuführen.

Am Gestell (39) und der Führung (40) sind geeignete Anschlüsse, z.B. an den Zapfen (48) oder an anderer Stelle, zum Ankuppeln der Versorgung (41) an die Halteeinheit (28) des oder der Werkstückträger (11) vorhanden. Der Manipulator (37) kann das Werkzeug (10) mit dem Werkstückträger (11) und dem String (3) wenden und mit der frei liegenden Sonnenseite (5) der Prüfeinrichtung (16) zuführen und die über die Oberseite des Werkstückträgers (11) ragenden Solarelemente (4) flächig auf die Prüfeinrichtung (16) legen. Die Prüfeinrichtung (16) prüft durch optische Abtastung oder auf anderem Wege die Solarelemente (4) auf Beschädigungsfreiheit oder andere Eigenschaften. Außerdem kann eine elektrische Leitungsprüfung durchgeführt werden, indem z.B. durch die Fügeöffnungen (27) elektrische Kontakte an die endseitigen Verbindungselemente (6) des Strings (3) angelegt werden.

Im Arbeitsbereich der Handhabungseinrichtung (9) können weitere Einrichtungen für zusätzliche Prozesse mit oder am String (3) angeordnet sein. Im besagten Arbeitsbereich befindet sich außerdem die eingangs erwähnte Zusammenbaueinrichtung (17) für ein Solarmodul (7). Hier werden eine oder mehrere Platten oder Lagen des Solarmoduls (7) zugeführt, übereinander geschichtet und miteinander verbunden. Hierbei wird zwischen zwei solche durchsichtige Lagen oder Folien mindestens ein String (3) von der Handhabungseinrichtung (9) eingelegt. Der String (3) wird hierbei über den Werkstückträger (11) exakt auf einer Glasplatte oder dgl. positioniert und durch Abschalten der Halteeinheit (12) vom Werkstückträger (11) gelöst. Zur Bildung des Solarmoduls (7) können mehrere Strings (3) in geeigneter Formation übergeben und abgelegt werden.

Figur 16 zeigt eine Variante der Herstellvorrichtung (2) von Figur 1. Die Änderungen betreffen insbesondere die Fertigungseinrichtung (8) mit den Zuführeinrichtungen (13,14) und der Transporteinrichtung (18). Die Handhabungseinrichtung (9) und die Fügeeinrichtung (15) sind in Figur 16 nicht dargestellt. Sie können die gleichen wie im ersten Ausführungsbeispiel von Figur 1 sein.

Bei der in Figur 16 gezeigten Transporteinrichtung (18) sind die Werkstückträger (11) jeweils einseitig über Schlitten (21), die an beiden Trägerenden angreifen, an einer Schiene (19) geführt. Die Werkstückträger (11) werden dabei schwebend neben den Schienen (19) gehalten. Sie sind dadurch leichter für die Handhabungseinrichtung (9) und deren Werkzeug (10) zugänglich.

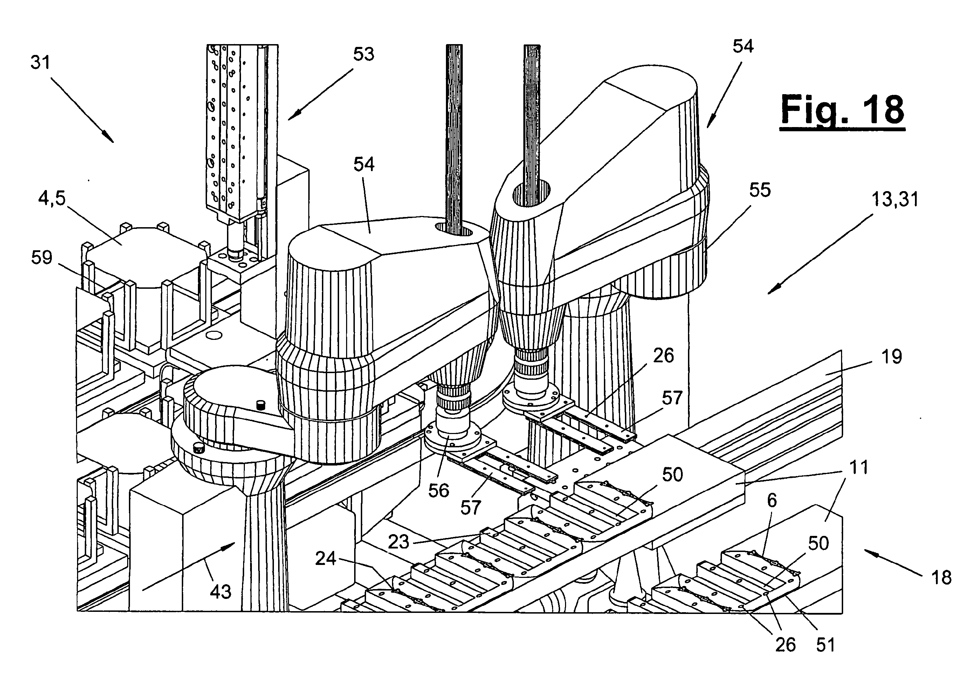

Die Zuführeinrichtung (13) für die Solarzellen (4) ist in Figur 17 und 18 detaillierter dargestellt. Die Solarzellen (4) sind in Stapeln (59) auf einem umlaufenden Förderer (60) gehalten. Die Solarzellen (4) werden einzeln von den Stapeln (59) mittels eines Einlegers (31) übernommen und den zuvor mit Verbindungselementen (6) bestückten Werkstückträgern (11) zugeführt. Die schrittweise Bestückung kann die gleiche wie im ersten Ausführungsbeispiel sein. In Abwandlung hierzu kann bei der Variante von Figur 16 zunächst ein Werkstückträger (11) komplett mit Verbindungselementen (6) an einer Schiene (19) bestückt werden, wobei er anschließend auf die andere Schiene (19) umgesetzt wird und dort mit Solarzellen (4) versehen wird.

Der Einleger (31) weist im Ausführungsbeispiel von Figur 16 eine Vereinzelungsvorrichtung (53) und einen Elementförderer (54) auf. Mit der Vereinzelungsvorrichtung (53) wird jeweils ein Solarelement (4) von einem oder von mehreren Stapeln (59) vereinzelt, anschließend vom Elementförderer (54) übernommen und dem Werkstückträger (11) zugeführt. Die Vereinzelungsvorrichtung (53) weist mindestens einen geeigneten Greifer (52), insbesondere den vorstehend beschriebenen berührungslosen Substratgreifer mit Vakuum und Ultraschall auf, der an einer Führung höhenverstellbar gehalten wird. In dem gezeigten Ausführungsbeispiel sind an einer Traverse zwei Greifer (52) nebeneinander angeordnet, die von benachbarten Stapeln (59) jeweils das oberste Solarelement greifen, vom Stapel (59) ablösen und anheben. Der Ablösevorgang kann durch eine in Figur 17 gezeigte stationäre Blaseinrichtung (62) unterstützt werden, die seitlich Luft gegen den Stapel (59) bläst.

Die ein oder mehreren abgehobenen und vereinzelten Solarelemente (4) können vom Elementförderer (54) mit einem Elementträger (56) übernommen, insbesondere an der weniger empfindlichen Rückseite untergriffen, zum Werkstückträger (11) transportiert und dort in einer Aufnahme (23) positioniert und abgesetzt werden. Der Elementförderer (54) weist hierfür einen geeigneten Manipulator (55) auf, der mehrere rotatorische und/oder translatorische Achsen haben kann. Im gezeigten Ausführungsbeispiel wird hierfür ein Scara-Roboter eingesetzt, der zwei Schwenkarme und zwei rotatorische Achsen sowie mindestens eine translatorische Achse, insbesondere eine lineare Höhenverstellung, aufweist, an welcher der Elementträger (56) angeordnet ist. Wie Figur 18 verdeutlicht, kann der Elementträger (56) einen oder mehrere Arme (57) zum Tragen des Solarelements (4) aufweisen. Diese können als einzelner breiterer Tragarm oder wie im gezeigten Ausführungsbeispiel als zwei oder mehr Gabelarme oder Zinken aus gebildet sein. Die ein oder mehreren Arme (57) untergreifen und übernehmen das vereinzelte Solarelement (4) in einer definierten Position. Die Arme (57) können hierfür eine geeignete steuerbare Haltevorrichtung, insbesondere eine Vakuumeinrichtung, aufweisen und z.B. entsprechende Saugöffnungen (26) an der Armoberfläche haben.

Wie Figur 8, Figur 9 in der oberen Bildhälfte und Figur 17 sowie 18 verdeutlichen, kann der Werkstückträger (11) an den Aufnahmen (23) für die Werkstücke bzw. Solarelemente (4) eine oder mehrere parallele, rinnen- oder nutenartige Vertiefungen (50) aufweisen, die an die Gabelarme (57) angepasst sind. Die quer zur Trägerlängsachse ausgerichteten und an einer Trägerseite offenen Vertiefungen (50) stellen Aufnahmen für den Elementträger (56) dar und können alternativ auch in anderer Weise ausgebildet sein. Bei der Übergabe der Solarelemente (4) taucht der Elementträger (56) mit den Armen (57) von oben in die entsprechend tiefen Aufnahmen (50) ein und legt dabei unter Lösen seiner Haltevorrichtung die Solarzelle (4) auf der Aufnahme (23) positionsgenau ab. Hierfür nimmt der Elementträger (56) eine definierte Position in den Horizontalachsen ein. Bei der Übergabe wird das Vakuum des Elementträgers (56) abgeschaltet, wobei die Halte- oder Vakuumeinrichtung (12) die Solarzelle (4) am Werkstückträger (11) fixiert. Der leere Elementträger (56) kann aus den Vertiefungen (50) seitlich herausgezogen und zur Übernahme des nächsten Solarelements (4) zum Förderer (60) bewegt werden.

Falls die Vereinzelungsvorrichtung (53), insbesondere der berührungslose Greifer (52), das oder die Solarelemente (4) nicht mit ausreichender Genauigkeit positioniert und an den Elementträger (56) übergibt, kann die IST-Lage des oder der Solarelemente (4) auf andere Weise, z.B. durch ein Vermessungssystem (nicht dargestellt), insbesondere ein Kamerasystem, vorzugsweise berührungslos erfasst und dem Elementförderer (54) mitgeteilt werden, damit dieser etwaige Lagefehler bei der Zuführung des oder der Solarelemente (4) zum Werkstückträger (11) korrigiert und den Elementträger (56) für die Übergabe exakt positioniert. Alternativ kann eine Führungseinrichtung (nicht dargestellt) eine evtl. Fehllage des oder der Solarelemente (4) an der Vereinzelungsvorrichtung (53), insbesondere am berührungslose Greifer (52), detektieren und korrigieren, was z.B. durch einen schonenden Angriff am Seitenrand des Solarelements (4) geschehen kann.

Die in Figur 17 detaillierter dargestellte Zuführeinrichtung (14) für die Verbindungselemente (6) weist ein Magazin (58) für die Verbindungselemente (6) auf, welches an einem Förderer (61) quer zur Führung (19) verfahren und über den Werkstückträgern (11) bewegt werden kann. Das Magazin (58) kann beweglich sein. Es ist z.B. als rotierender Revolver ausgebildet, der in seinem Umfang mehrere Zuführmittel (32), z.B. die vorerwähnten Picker, aufweist und diese um die horizontale Revolverachse dreht. Das Magazin (58) kann mehrere Verbindungselemente (6) gleichzeitig an den Werkstückträger (11) übergeben.

Die Zuführeinrichtungen (13,14) können bei der Ausführungsform von Figur 16 ebenfalls in der Prozessablaufrichtung (43) zueinander versetzt sein, wobei die Werkstückträger (11) schrittweise nacheinander mit Verbindungselementen (6) und anschließend mit Solarzellen (4) bestückt werden. Die Zuführeinrichtungen(13,14) können in ihrer Beweglichkeit derart ausgebildet sein, dass sie zwei oder mehr parallele Werkstückträger (11) bedienen können.

Abwandlungen der gezeigten und beschriebenen Ausführungsformen sind in verschiedener Weise möglich. Die konstruktive Gestaltung der Teile der Herstellvorrichtung (2) und der Herstellanlage (1) können variieren. Dies gilt auch für die Formgebung des Werkstückträgers (11) und der Zuführeinrichtungen (13,14).

### BEZUGSZEICHENLISTE

- 1: Anlage, Herstellanlage
- 2: Herstellvorrichtung, Stringer
- 3: Kette, String
- 4: Stringteil, Werkstück, Solarelement, Solarzelle
- 5: solaraktive Seite, Oberseite, Sonnenseite
- 6: Stringteil, Verbindungselement
- 7: Solarmodul
- 8: Fertigungseinrichtung, Fertigungslinie
- 9: Handhabungseinrichtung
- 10: Werkzeug, Wechselträger
- 11: Werkstückträger
- 12: Halteeinrichtung, Vakuumeinrichtung
- 13: Zuführeinrichtung für Werkstücke
- 14: Zuführeinrichtung für Verbinder
- 15: Fügeeinrichtung, Löteinrichtung
- 16: Prüfeinrichtung
- 17: Zusammenbaueinrichtung
- 18: Transporteinrichtung
- 19: Führung
- 20: Förderer
- 21: Fördermittel, Schlitten
- 22: Versorgung für Halteeinheit, Vakuumquelle
- 23: Aufnahme für Werkstück
- 24: Aufnahme für Verbinder
- 25: Positioniereinrichtung
- 26: Öffnung, Saugöffnung
- 27: Öffnung, Fügeöffnung
- 28: Halteeinheit, Vakuumeinheit
- 29: Saugkanal
- 30: Anschluss
- 31: Einleger
- 32: Zuführmittel, Picker
- 33: Mittelsteg
- 34: Arm, Quersteg, Verdickung
- 35: Öffnung
- 36: Fügepunkt, Lötpunkt
- 37: Manipulator, Roboter
- 38: Hand
- 39: Gestell
- 40: Führung
- 41: Versorgung für Halteeinheit, Vakuumquelle
- 42: Strahlkopf, Laserkopf
- 43: Prozessablaufrichtung
- 44: Überbrückungseinrichtung, Ventil
- 45: Einrichtung zur Kontaktsicherung, Federelement
- 46: Anschluss
- 47: Klemmleiste
- 48: Zapfen
- 49: Stelleinrichtung
- 50: Aufnahme für Elementträger, Rinne
- 51: Führungselement, Rand
- 52: Greifer, Substratgreifer
- 53: Vereinzelungsvorrichtung
- 54: Elementförderer
- 55: Manipulator, Scara-Roboter
- 56: Elementträger, Gabel
- 57: Arm, Zinke, Gabelarm
- 58: Magazin, Revolver
- 59: Stapel
- 60: Förderer für Solarelemente
- 61: Förderer für Verbindungselemente
- 62: Blaseinrichtung

## Patentansprüche

1. Herstellvorrichtung für Strings (3) aus mehreren untereinander mit Verbindungselementen (6) verbundenen Solarelementen (4), wobei die Herstellvorrichtung (2) eine Fertigungseinrichtung (8) für die Stringbildung aufweist, **dadurch gekennzeichnet, dass** die Herstellvorrichtung (2) einen oder mehrere bewegliche Werkstückträger (11) zur Aufnahme von mindestens einem String (3), eine mehrachsig bewegliche Handhabungseinrichtung (9) mit einem Werkzeug (10) zum Zu- und Abführen des Werkstückträgers (11) zu und von der Fertigungseinrichtung (8) und eine steuerbare Halteeinrichtung (12) aufweist, welche mit dem Werkzeug (10) und der Fertigungseinrichtung (8) verbunden ist und den String (3) und seine Teile (4,6) während der Stringherstellung und der Handhabung am Werkstückträger (11) hält.

2. Herstellvorrichtung nach Anspruch 1, **dadurch gekennzeichnet, dass** die Fertigungseinrichtung (8) eine Transporteinrichtung (18), mindestens eine Zuführeinrichtung (13,14) und einer Fügeeinrichtung (15) für die Solarelemente (4) und die Verbindungselemente (6) aufweist.

3. Herstellvorrichtung nach Anspruch 1 oder 2, **dadurch gekennzeichnet, dass** die Transporteinrichtung (18) mindestens einen Förderer (20) zur lösbaren Aufnahme von einem oder mehreren Werkstückträgern (11) aufweist.

4. Herstellvorrichtung nach Anspruch 1, 2 oder 3, **dadurch gekennzeichnet, dass** die Handhabungseinrichtung (9) einen mehrachsigen Manipulator (37) mit einem Werkzeug (10) zur lösbaren Aufnahme von mindestens einem Werkstückträger (11) aufweist.

5. Herstellvorrichtung nach einem der vorhergehenden Ansprüche, **dadurch gekennzeichnet, dass** die Herstellvorrichtung (2) eine Prüfeinrichtung (16) im Arbeitsbereich der Handhabungseinrichtung (9) aufweist.

6. Herstellvorrichtung nach einem der vorhergehenden Ansprüche, **dadurch gekennzeichnet, dass** die Herstellvorrichtung (2) mindestens eine Positioniereinrichtung (25) für den String (3) und seine Teile (4,6) und für den Werkstückträger (11) aufweist.

7. Herstellvorrichtung nach einem der vorhergehenden Ansprüche, **dadurch gekennzeichnet, dass** die Zuführeinrichtung (13) mindestens einen Greifer (52) zum berührungslosen Greifen eines Solarelements (4) aufweist.

8. Herstellvorrichtung nach einem der vorhergehenden Ansprüche, **dadurch gekennzeichnet, dass** die Halteeinrichtung (12) eine Halteeinheit (28), insbesondere eine Vakuumeinheit, am Werkstückträger (11) und mindestens eine mitführbare oder ankuppelbare Versorgung (22,41) für die Halteeinheit (28) an der Handhabungseinrichtung (9) und der Transporteinrichtung (18) aufweist, wobei die Halteeinheit (28) eine Überbrückungseinrichtung (44) zur Aufrechterhaltung der Haltefunktion während Übergaben des Werkstückträgers (11) bei abgekuppelter Versorgung (22,41) aufweist.

9. Herstellvorrichtung nach einem der vorhergehenden Ansprüche, **dadurch gekennzeichnet, dass** der Werkstückträger (11) mehrere angepasste Aufnahmen (23) für Werkstücke (4), insbesondere Solarelemente, und mehrere angepasste Aufnahmen (24) für Verbindungselemente (6) aufweist, wobei die Aufnahmen (24) in einem Zwischenraum und mit Höhenversatz zu den angrenzenden und beabstandeten Aufnahmen (23) für die Werkstücke (4) angeordnet sind und wobei die Aufnahmen (23,24) an der Oberseite des Werkstückträgers (11) angeordnet sowie als Vertiefungen mit Führungselementen (51) ausgebildet sind.

10. Herstellvorrichtung nach einem der vorhergehenden Ansprüche, **dadurch gekennzeichnet, dass** die Fügeeinrichtung (15) einen Strahlkopf (42), vorzugsweise einen Laserkopf aufweist, wobei am Werkstückträger (11) im Bereich der Aufnahmen (23,24) eine oder mehrere Fügeöffnungen (27) für den Durchtritt eines energiereichen Strahls, vorzugsweise eines Laserstrahls angeordnet sind.

11. Herstellanlage für Solarmodule (7) mit einer Herstellvorrichtung (2) für Strings (3) aus mehreren untereinander verbundenen Solarelementen (4) und einer Zusammenbaueinrichtung (17) für die Strings (3) und die Modullagen, **dadurch**
**gekennzeichnet, dass** die Herstellvorrichtung (2) nach einem der Ansprüche 1 bis 10 ausgebildet ist.

12. Verfahren zum Herstellen von Strings (3) aus mehreren untereinander mit Verbindungselementen (6) verbundenen Solarelementen (4) mittels einer Fertigungseinrichtung (8), **dadurch gekennzeichnet, dass** die Verbindungselemente (6) und die Solarelemente (4) zur Stringbildung in der Fertigungseinrichtung (8) zugeführt und auf einen beweglichen Werkstückträger (11) appliziert werden, mit dem sie anschließend gemeinsam bewegt werden, wobei der Werkstückträger (11) von einer mehrachsig beweglichen Handhabungseinrichtung (9) mit einem Werkzeug (10) zu und von der Fertigungseinrichtung (8) zu- und abgeführt wird und wobei der String (3) und seine Teile (4,6) während der Stringherstellung und der Handhabung mittels einer steuerbaren und mit dem Werkzeug (10) und der Fertigungseinrichtung (8) verbundenen Halteeinrichtung (12) am Werkstückträger (11) gehalten werden.

13. Verfahren nach Anspruch 12, **dadurch gekennzeichnet, dass** der String (3) von der Handhabungseinrichtung (9) einer Prüfeinrichtung (16) zugeführt und während der Prüfung am Werkstückträger (11) gehalten wird.

14. Verfahren nach Anspruch 12 oder 13, **dadurch gekennzeichnet, dass** die Solarelemente (4) ohne mechanischen Berührungskontakt mit ihrer solaraktiven Oberfläche (5) gegriffen werden.

15. Verfahren nach einem der Ansprüche 12 bis 14, **dadurch gekennzeichnet, dass** die Verbindungselemente (6) und die Solarelemente (4) am Werkstückträger (11) gefügt, insbesondere mit einem durch den Werkstückträger (11) gerichteten Laserstrahl verbunden, vorzugsweise verlötet werden.

## Claims

1. Production device for strings (3) comprising a number of solar elements (4) connected to one another by connecting elements (6), the production device (2) having a fabricating device (8) for forming the strings, **characterized in that** the production device (2) has one or more movable workpiece carriers (11) for receiving at least one string (3), a multiaxially movable handling device (9) with a tool (10) for guiding the workpiece carrier (11) towards and away from the fabricating device (8), and a controllable holding device (12), which is connected to the tool (10) and the fabricating device (8) and holds the string (3) and parts (4, 6) thereof on the workpiece carrier (11) during string production and handling.

2. Production device according to Claim 1, **characterized in that** the fabricating device (8) has a transporting device (18), at least one feeding device (13, 14) and a joining device (15) for the solar elements (4) and the connecting elements (6).

3. Production device according to Claim 1 or 2, **characterized in that** the transporting device (18) has at least one conveyor (20) for releasably receiving one or more workpiece carriers (11).

4. Production device according to Claim 1, 2 or 3, **characterized in that** the handling device (9) has a multiaxial manipulator (37) with a tool (10) for releasably receiving at least one workpiece carrier (11).

5. Production device according to one of the preceding claims, **characterized in that** the production device (2) has a testing device (16) in the operating area of the handling device (9).

6. Production device according to one of the preceding claims, **characterized in that** the production device (2) has at least one positioning device (25) for the string (3) and parts (4, 6) thereof and for the workpiece carrier (11).

7. Production device according to one of the preceding claims, **characterized in that** the feeding device (13) has at least one gripper (52) for contactlessly gripping a solar element (4).

8. Production device according to one of the preceding claims, **characterized in that** the holding device (12) has a holding unit (28), in particular a vacuum unit, on the workpiece carrier (11) and at least one supply means (22, 41), which can be carried along or attached by coupling, for the holding unit (28) on the handling device (9) and the transporting device (18), the holding unit (28) having a bridging device (44) for maintaining the holding function during transfer of the workpiece carrier (11) with the supply means (22, 41) uncoupled.

9. Production device according to one of the preceding claims, **characterized in that** the workpiece carrier (11) has a number of adapted receptacles (23) for workpieces (4), in particular solar elements, and a number of adapted receptacles (24) for connecting elements (6), the receptacles (24) being arranged in an intermediate space and with a height offset in relation to the adjacent and spaced-apart receptacles (23) for the workpieces (4), and the receptacles (23, 24) being arranged on the upper side of the workpiece carrier (11) and formed as recesses with guiding elements (51).

10. Production device according to one of the preceding claims, **characterized in that** the joining device (15) has a beam head (42), preferably a laser head, one or more joining openings (27) for the passing through of a high-energy beam, preferably a laser beam, being arranged on the workpiece carrier (11) in the region of the receptacles (23, 24).

11. Production installation for solar modules (7) with a production device (2) for strings (3) comprising a number of solar elements (4) connected to one another and an assembly device (17) for the strings (3) and the layers of modules, **characterized in that** the production device (2) is formed according to one of Claims 1 to 10.

12. Method for producing strings (3) from a number of solar elements (4) connected to one another by connecting elements (6) by means of a fabricating device (8), **characterized in that** the connecting elements (6) and the solar elements (4) are fed to the string formation in the fabricating device (8) and are applied to a movable workpiece carrier (11), with which they are subsequently moved altogether, the workpiece carrier (11) being guided towards and away from the fabricating device (8) by a multiaxially movable handling device (9) with a tool (10), and the string (3) and parts (4, 6) thereof being held on the workpiece carrier (11) during string production and handling by means of a controllable holding device (12) connected to the tool (10) and the fabricating device (8).

13. Method according to Claim 12, **characterized in that** the string (3) is fed by the handling device (9) to a testing device (16) and is held on the workpiece carrier (11) during the testing.

14. Method according to Claim 12 or 13, **characterized in that** the solar elements (4) are gripped without any mechanical contact with their solar-active surface (5).

15. Method according to one of Claims 12 to 14, **characterized in that** the connecting elements (6) and the solar elements (4) are joined to the workpiece carrier (11), in particular are connected, preferably soldered, by a laser beam directed through the workpiece carrier (11).

## Revendications

1. Ensemble de formation de chaînes (3) constituées de plusieurs éléments solaires (4) reliés les uns aux autres par des éléments de liaison (6),
l'ensemble de formation (2) présentant un dispositif de fabrication (8) destiné à former les chaînes,
**caractérisé en ce que**
l'ensemble de formation (2) présente
un ou plusieurs porte-pièces (11) mobiles qui reprennent au moins une chaîne (3),
un dispositif mobile de manipulation (9) à plusieurs axes doté d'un outil (10) qui amène le porte-pièces (11) vers le dispositif de fabrication (8) et l'en éloigne et
un dispositif asservi de maintien (12) qui est relié à l'outil (10) et au dispositif de fabrication (8) et qui maintient la chaîne (3) et ses parties (4, 6) sur le porte-pièces (11) pendant la formation de la chaîne et les manipulations.

2. Ensemble de formation selon la revendication 1, **caractérisé en ce que** le dispositif de fabrication (8) présente un dispositif de transport (18), au moins un dispositif d'amenée (13, 14) ainsi qu'un dispositif de jonction (15) prévu pour relier les éléments solaires (4) aux éléments de liaison (6).

3. Ensemble de formation selon les revendications 1 ou 2, **caractérisé en ce que** le dispositif de transport (18) présente au moins un transporteur (20) qui reprend de manière libérable un ou plusieurs porte-pièces (11).

4. Ensemble de formation selon les revendications 1, 2 ou 3, **caractérisé en ce que** le dispositif de manipulation (9) présente un manipulateur (37) à plusieurs axes doté d'un outil (10) qui reprend de manière libérable au moins un porte-pièces (11).

5. Ensemble de formation selon l'une des revendications précédentes, **caractérisé en ce que** l'ensemble de formation (2) présente un dispositif de vérification (16) prévu dans la partie de travail du dispositif de manipulation (9).

6. Ensemble de formation selon l'une des revendications précédentes, **caractérisé en ce que** l'ensemble de formation (2) présente au moins un dispositif de positionnement (25) prévu pour la chaîne (3) et ses parties (4, 6) ainsi que pour le porte-pièces (11).

7. Ensemble de formation selon l'une des revendications précédentes, **caractérisé en ce que** le dispositif d'amenée (13) présente au moins un dispositif de saisie (52) qui saisit sans contact un élément solaire (4).

8. Ensemble de formation selon l'une des revendications précédentes, **caractérisé en ce que** le dispositif de maintien (12) présente une unité de maintien (28), en particulier une unité sous vide, prévue sur le porte-pièces (11) et au moins une alimentation (22, 41) qui peut être entraînée conjointement ou accouplée prévue pour l'unité de maintien (28) sur le dispositif de manipulation (9) et sur le dispositif de transport (18), l'unité de maintien (28) présentant un dispositif de pontage (44) qui maintient la fonction de maintien pendant le transfert du porte-pièces (11) lorsque l'alimentation (22, 41) est désaccouplée.

9. Ensemble de formation selon l'une des revendications précédentes, **caractérisé en ce que** le porte-pièces (11) présente plusieurs logements (23) adaptés pour les pièces (4), en particulier les éléments solaires, et plusieurs logements (24) adaptés pour les éléments de liaison (6), les logements (24) étant disposés dans un espace intermédiaire, décalés en hauteur par rapport aux logements (23), adjacents et maintenus à distance, prévus pour les pièces (4), les logements (23, 24) étant disposés sur le côté supérieur du porte-pièces (11) et étant configurés en forme de creux dotés d'éléments de guidage (51).

10. Ensemble de formation selon l'une des revendications précédentes, **caractérisé en ce que** le dispositif de jonction (15) présente une tête (42) émettant un rayonnement, de préférence une tête laser, une ou plusieurs ouvertures de jonction (27) permettant le passage d'un faisceau à haute énergie, de préférence d'un faisceau laser, étant prévues sur le porte-pièces (11) au niveau des logements (23, 24).

11. Installation de formation de modules solaires (7) dotée
d'un ensemble de formation (2) de chaînes (3) constitué de plusieurs éléments solaires (4) reliés les uns aux autres et
d'un ensemble d'assemblage (17) des chaînes (3) et des couches de module,
**caractérisée en ce que**
l'ensemble de formation (2) est configuré selon l'une des revendications 1 à 10.

12. Procédé pour former des chaînes (3) constituées de plusieurs éléments solaires (4) reliés les uns aux autres par des éléments de liaison (6) au moyen d'un dispositif de fabrication (8),
le procédé étant **caractérisé en ce que**
les éléments de liaison (6) et les éléments solaires (4) sont amenés dans le dispositif de fabrication (8) pour former les chaînes et sont posés sur un porte-pièces (11) mobile par lequel ils sont ensuite déplacés conjointement,
le porte-pièces (11) étant approché et éloigné du dispositif de fabrication (8) par un dispositif mobile de manipulation (9) à plusieurs axes doté d'un outil (10),
la chaîne (3) et ses parties (4, 6) étant maintenues sur le porte-pièces (11) pendant la formation de la chaîne et les manipulations au moyen d'un dispositif de maintien (12) commandé et relié à l'outil (10) et au dispositif de fabrication (8).

13. Procédé selon la revendication 12, **caractérisé en ce que** la chaîne (3) est amenée à un dispositif de vérification (16) par le dispositif de manipulation (9) et est maintenue sur le porte-pièces (11) pendant la vérification.

14. Procédé selon les revendications 12 ou 13, **caractérisé en ce que** les éléments solaires (4) sont saisis par leurs surfaces (5) solairement actives sans contact mécanique.

15. Procédé selon l'une des revendications 12 à 14, **caractérisé en ce que** les éléments de liaison (6) et les éléments solaires (4) sont reliés sur le porte-pièces (11), en particulier sont reliés, de préférence brasés, par un faisceau laser qui traverse le porte-pièces (11).
